# EUROPÄISCHE PATENTSCHRIFT

(11) **EP 3 361 282 B1**
(45) Veröffentlichungstag und Bekanntmachung des Hinweises auf die Patenterteilung: **18.03.2020**
(21) Anmeldenummer: 17155771.3
(22) Anmeldetag: 13.02.2017
(51) Int. Cl.: G01S 7/486

(54) **OPTISCHER SENSOR MIT BEGRENZERSCHALTUNG**
OPTICAL SENSOR WITH LIMITER CIRCUIT
CAPTEUR OPTIQUE AVEC CIRCUIT LIMITEUR

(43) Veröffentlichungstag der Anmeldung: 15.08.2018
(73) Patentinhaber: Leuze electronic GmbH + Co. KG, 73277 Owen/Teck (DE)
(72) Erfinder: KAPPELER, Franz, 82178 Puchheim (DE); AUER, Robert, 85540 Haar (DE)
(74) Vertreter: Ruckh, Rainer Gerhard

(56) Entgegenhaltungen:
- EP-A1- 1 990 656
- EP-A1- 2 388 619
- EP-A1- 2 597 483
- EP-A2- 1 291 673
- EP-A2- 1 901 092
- WO-A1-02/23690
- DE-A1- 3 218 439
- DE-A1- 19 607 345
- Maximilian Hauske: "Signalverarbeitung für optoelektronische Sensoren", , 1. Januar 2012 (2012-01-01), XP055389122, Gefunden im Internet: URL:https://publikationen.bibliothek.kit.e du/1000028706/2171986 [gefunden am 2017-07-07]

## Beschreibung

Die Erfindung betrifft einen optischen Sensor und ein Verfahren zur Erfassung von Objekten in einem Überwachungsbereich.

Derartige optische Sensoren sind insbesondere als Distanzsensoren ausgebildet, bei welchen eine Distanzmessung nach einem Puls-Laufzeit-Verfahren durchgeführt wird. Hierzu weist der optische Sensor einen Sender auf, welcher Sendelichtstrahlen in Form von Sendelichtimpulsen emittiert. Die von einem Objekt reflektierten Sendelichtimpulse werden auf einen Empfänger des optischen Sensors geführt. In einer Auswerteeinheit wird dann die Laufzeit der Sendelichtimpulse berechnet, woraus dann die Distanz des Objekts zum optischen Sensor berechnet wird.

Die Oberflächen der zu detektierenden Objekte können stark unterschiedliche Reflektivitäten aufweisen. Je nach Reflektivität der Objektoberfläche variiert das von einem Sendlichtimpuls stammende Empfangssignal stark hinsichtlich seiner Pulsbreite und seiner Anstiegszeit. Dadurch entsteht bei der LaufzeitMessung ein Messfehler, der sogenannte Walk-Error, da der Triggerzeitpunkt für das Registrieren des Empfangssignals von der Signalform des Empfangssignals abhängt.

Dieser Messfehler kann durch eine Amplitudenmessung des Empfangssignals und eine Kalibrierung des Empfangssignals anhand einer Aufnahme der im Messbetrieb ermittelten Wertetabelle kompensiert werden.

Diese Messfehlerkorrektur funktioniert jedoch dann nicht mehr, wenn das Objekt, beispielsweise gebildet von einem Reflektor, das auftreffende Sendelicht so stark reflektiert, dass der Empfänger aufgrund der hohen registrierten Empfangssignalamplitude übersteuert, das heißt in Sättigung geht.

Um auch derartig stark reflektierende Objekte erfassen zu können ist es bekannt, dem Empfänger Begrenzerstufen zuzuordnen. Diese Begrenzerstufen enthalten eine Regelung, die auf den Eingang des Empfängers zurückwirkt.

Ein wesentlicher Nachteil hierbei besteht darin, dass diese Regelung erst dann aktiv werden kann, wenn ein erstes Empfangssignal empfangen wurde. Anhand dessen kann dann die Regelung für das nächste Empfangssignal durchgeführt werden.

Eine solche Begrenzung des Empfangssignals kann nur in den Fällen durchgeführt werden, bei welchen mehrere Sendelichtimpulse unmittelbar nacheinander auf das zu detektierende Objekt geführt werden, so dass sich dessen Position während der Messungen nicht ändert.

In vielen Anwendungsfällen ist diese Voraussetzung nicht erfüllt. Dies gilt insbesondere bei scannenden Distanzsensoren. Dort werden die Sendelichtstrahlen des Senders des optischen Sensors periodisch innerhalb des Überwachungsbereichs geführt. Durch diese Ablenkbewegung wird ein Objekt typischerweise nur mit einem Sendelichtimpuls erfasst. Daher ist auch eine Nachregelung des Empfangssignals prinzipiell nicht möglich.

Die EP 1 990 656 A1 betrifft einen optischen Entfernungsmesser mit einem Lichtsender zum Aussenden von Messlicht in einen Überwachungsraum, einem Lichtempfänger zum Empfang von durch ein Objekt im Überwachungsraum reflektiertem bzw. remittiertem Messlicht und einer Auswerteschaltung, um aus dem Ausgangssignal des Lichtempfängers die Laufzeit des Messlichtes und daraus die Entfernung des Objektes zu bestimmen. Zwischen dem Lichtempfänger und der Auswerteschaltung ist eine elektrisch mit diesen verbundene pin-Diodenschaltung vorgesehen, wobei die pin-Diodenschaltung das Strom-Ausgangssignal des Lichtempfängers dämpft.

In Maximilian Hauske: "Signalverarbeitung für optoelektronische Sensoren", 1. Januar 2012 (2012-01-01), XP055389122, gefunden im Internet: URL: https:// publikationen.bibliothek.kit.edu/1000028706/2171986, sind Methoden der Signalverarbeitung für optoelektronische Sensoren beschrieben. Insbesondere ist eine mehrstufige Struktur zur Begrenzung der Eingangsamplitude beschrieben, die aus zwei hintereinander geschalteten Soft-Limitern besteht. Diese Soft-Limiter begrenzen bei Überschreiten eines Schwellwerts T1 bzw. T2 die Amplitude nicht-linear und ansonsten linear.

Die DE 32 18 439 A1 betrifft eine Schaltungsanordnung für einen opto/elektrischen Wandler, der in einer mindestens einen Lichtwellenleiter aufweisenden Übertragungsstrecke für digitale Signale in einem Regeneratorpunkt oder in einem Endgestell angeordnet ist und der einen optischen Empfänger, an den der Lichtwellenleiter angeschlossen ist, mit nachgeschaltetem Transimpedanzverstärker aufweist. Am Ausgang des Empfängers ist zwischen demselben und dem Transimpedanzverstärker ein ohmscher Widerstand angeschlossen. Am Ausgang des Empfängers ist außerdem ein elektrisches Element mit spannungsabhängigem Widerstand angeschlossen, dessen Schwellspannung derart bemessen ist, dass der zum Transimpedanzverstärker fließende Strom auf einen maximal zulässigen Wert begrenzt ist.

Die WO 02/23690 A1 betrifft einen Photodetektor für einen Sensor. Um Beschädigungen des Photodetektors zu vermeiden, ist diesem ein variabler Impedanz-Transistor zugeordnet, dessen Widerstand mit steigendem Stromfluss durch den Photodetektor steigt. EP2597483 offenbart einen elektro-optischen Entfernungsmesser mit zwei Verstärkerstufen zum Schutz vor Sättigung, um den Dynamikbereich der vom Empfänger erfassbaren Lichtintensität zu verbessern.

Der Erfindung liegt die Aufgabe zugrunde, einen optischen Sensor und ein Verfahren für eine schnelle und zuverlässige Objekterfassung für Objekte mit unterschiedlichen Reflektivitäten bereitzustellen.

Zur Lösung dieser Aufgabe sind die Merkmale der unabhängigen Ansprüche vorgesehen. Vorteilhafte Ausführungsformen und zweckmäßige Weiterbildungen der Erfindung sind in den abhängigen Ansprüchen beschrieben.

Die Erfindung betrifft einen optischen Sensor zur Erfassung von Objekten in einem Überwachungsbereich und umfasst einen Sender, welcher Sendelichtstrahlen in Form von Sendelichtimpulsen emittiert, sowie einen Sendelichtimpulse empfangenden Empfänger. Mit einer Auswerteeinheit werden am Ausgang des Empfängers anstehende Empfangssignale zur Generierung eines Objektfeststellungssignals ausgewertet. Dem Empfänger ist eine Begrenzerschaltung nachgeordnet, welche zwei Begrenzerstufen aufweist. Eine erste Begrenzerstufe ist von einer Längsstufe gebildet, welche bei Überschreiten einer Grenzamplitude des Empfangssignals hochohmig ist. Eine zweite Begrenzerstufe ist von einer Querstufe gebildet, mittels derer bei Überschreiten der oder einer weiteren Grenzamplitude des Empfangssignals ein Teil dieses Empfangssignals nach Masse abgeleitet ist. In der Begrenzerschaltung ist unterhalb der oder jeder Grenzamplitude das Empfangssignal nicht begrenzt.

Die Erfindung betrifft weiterhin ein entsprechendes Verfahren.

Mit dem erfindungsgemäßen optischen Sensor können durch die Begrenzung des Empfangssignals mit der zweistufigen Begrenzerschaltung Objekte auch mit stark unterschiedlich reflektierenden Oberflächen schnell und zuverlässig erkannt werden.

Besonders vorteilhaft ist der optische Sensor ein nach einem Puls-Laufzeit-Verfahren arbeitender Distanzsensor, wobei der Empfänger von einer Avalanche-Photodiode gebildet sein kann. Alternativ kann auch ein Array, das heißt eine Mehrfachanordnung von Avalanche-Photodioden vorgesehen sein.

Bei der Durchführung der Laufzeitmessungen kann der Walk-Error als durch unterschiedliche Objektreflektivitäten bedingter Laufzeitmessfehler durch eine geeignete Kalibrierung der Empfangssignale für Objekte mit beliebigen Reflektivitäten kompensiert werden, da mit der erfindungsgemäßen Begrenzerschaltung ein Übersteuern des Empfängers, der eine solche Kalibrierung unmöglich machen würde, selbst bei hochreflektierenden Objekten wie Reflektoren vermieden wird. Damit ist unabhängig von der Reflektivität eines Objekts eine zuverlässige und fehlerfreie Laufzeitmessung und damit Distanzbestimmung gewährleistet.

Ein wesentlicher Vorteil des erfindungsgemäßen optischen Sensors besteht auch darin, dass die Begrenzerschaltung eine wirksame Begrenzung des Empfangssignals bei schnellen Detektionsvorgängen ermöglicht. Auch wenn ein Objekt nur mit einem Sendelichtimpuls erfasst wird und dementsprechend nur ein Empfangssignal zur Objektdetektion zur Verfügung steht, ist eine fehlerfreie Objektdetektion gewährleistet, da die Begrenzerschaltung unmittelbar und rückwirkungsfrei auf das Empfangssignal wirkt. Dies stellt einen wesentlichen Vorteil gegenüber mit Regelungen arbeitenden Begrenzungsstufen dar, da dort zunächst ein erstes Empfangssignal empfangen werden muss, um dann anhand dessen das zweite Empfangssignal geeignet zu regeln.

Derartige schnelle Objektdetektionen werden insbesondere bei scannenden Distanzsensoren benötigt, bei welchen die Sendelichtstrahlen periodisch in dem Überwachungsbereich geführt sind.

Dabei kann der optische Sensor eine Ablenkeinheit aufweisen, mittels derer die vom Sender emittierten Sendelichtstrahlen periodisch innerhalb des Überwachungsbereichs geführt sind.

Alternativ können bei dem optischen Sensor der Sender und der Empfänger in einem rotierenden Messkopf gelagert sein. Durch die Drehbewegung des Messkopfs sind die vom Sender emittierten Sendelichtstrahlen periodisch innerhalb des Überwachungsbereichs geführt.

Bei derartigen scannenden Distanzsensoren wird ein Objekt oft nur mit einem einzelnen Sendelichtimpuls erfasst, so dass dort entsprechend ein einzelnes Empfangssignal in seiner Amplitude begrenzt werden muss, was mit der erfindungsgemäßen Begrenzerschaltung möglich ist.

Ein wesentlicher Aspekt der Erfindung besteht darin, dass mit der Begrenzerschaltung Empfangssignale mit kleinen Amplituden nicht begrenzt werden. Demgegenüber werden Empfangssignale mit hohen Amplituden mit der Begrenzerschaltung nichtlinear begrenzt.

Vorteilhaft ist der Arbeitspunkt der Begrenzerschaltung einstellbar, so dass vorgesehen werden kann, ab welcher Grenzamplitude die nichtlineare Begrenzung einsetzt. Durch diese Einstellmöglichkeit ist die Begrenzerschaltung insbesondere robust gegen Exemplarstreuungen der einzelnen Bauteile. Dabei können die beiden Begrenzerstufen der Begrenzerschaltung, die vorteilhaft unabhängig voneinander arbeiten, separat eingestellt werden. Insbesondere kann die Wirkung der Längsstufe bei einer ersten Grenzamplitude des Empfangssignals einsetzen. Die Wirkung der Querstufe kann bei einer zweiten Grenzamplitude des Empfangssignals einsetzen. Insbesondere können beide Grenzamplituden auch gleich gewählt werden.

Ein wesentlicher Aspekt der erfindungsgemäßen Begrenzerschaltung besteht darin, dass die Längs- und Querstufe so aufeinander abgestimmt sind, dass bei hohen Amplituden des Empfangssignals dieses nichtlinear derart begrenzt wird, dass dabei der Empfänger nicht übersteuert wird und die Pulsbreite des von einem Sendelichtimpuls stammenden Empfangssignals kontinuierlich mit steigender empfangender Lichtleistung zunimmt.

Damit kann die gemessene Pulsbreite des Empfangssignals zur Korrektur der jeweiligen Laufzeitmessung herangezogen werden. Insbesondere kann auf diese Weise der Walk-Error der Laufzeitmessung kompensiert werden, so dass auch bei hohen Objektreflektivitäten eine genaue Laufzeitmessung und damit Distanzmessung möglich ist.

Gemäß einer vorteilhaften Ausgestaltung sind die am Empfänger anstehenden Empfangssignale über die Begrenzerschaltung und eine Verstärkerstufe der Auswerteeinheit zugeführt.

Mit der Verstärkung der Empfangssignale am Ausgang der Begrenzerschaltung wird die Nachweisempfindlichkeit bei der Objektdetektion weiter erhöht.

Gemäß einer zweckmäßigen Weiterbildung der Erfindung ist der Strom durch den Empfänger durch eine Strombegrenzungsstufe begrenzt.

Mit dieser Strombegrenzungsstufe wird die Amplitude des Empfangssignals von vorne herein begrenzt.

Die Erfindung wird im Folgenden anhand der Zeichnungen erläutert. Es zeigen:
- Figur 1:: Schematische Darstellung eines Ausführungsbeispiels des erfindungsgemäßen optischen Sensors.
- Figur 2:: Empfangssignale des optischen Sensors gemäß Figur 1 für unterschiedliche Obj ektreflektivitäten.
- Figur 3:: Erstes Ausführungsbeispiel einer Begrenzerschaltung mit einer Verstärkerstufe für den optischen Sensor gemäß Figur 1.
- Figur 4:: Ausgangssignale der Begrenzerschaltung gemäß Schaltungsanordnung gemäß Figur 3 für unterschiedliche Lichtleistungen am Empfänger des optischen Sensors.
- Figur 5:: Übertragungskennlinie der Schaltungsanordnung gemäß Figur 3.
- Figur 6:: Verlauf der Pulsbreite des Ausgangssignals der Schaltungsanordnung gemäß Figur 3.
- Figur 7:: Verlauf der Anstiegszeit des Ausgangssignals der Schaltungsanordnung gemäß Figur 3 in Abhängigkeit der Lichtleistung am Empfänger des optischen Sensors.
- Figur 8:: Zweites Ausführungsbeispiel einer Begrenzerschaltung mit einer Verstärkerstufe für den optischen Sensor gemäß Figur 1.

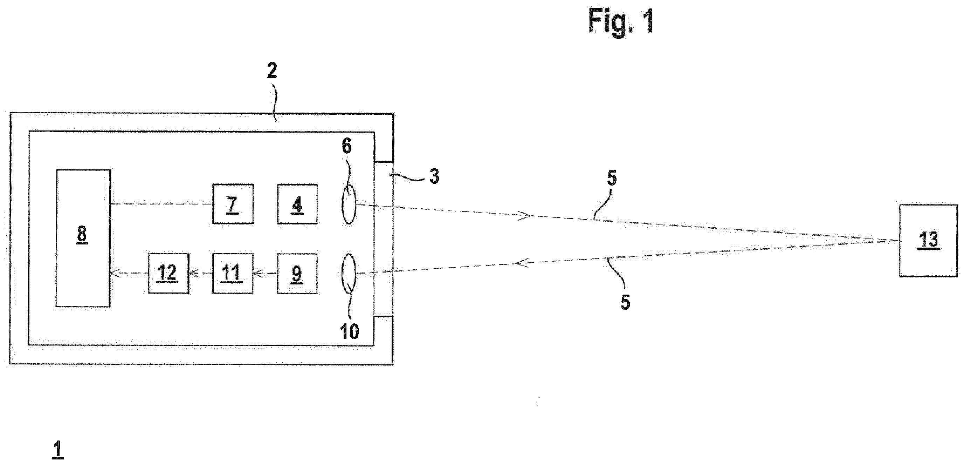

Figur 1 zeigt schematisch den Aufbau eines Ausführungsbeispiels des erfindungsgemäßen optischen Sensors 1. Der optische Sensor 1 ist im vorliegenden Fall von einem nach einem Puls-Laufzeit-Verfahren arbeitenden Distanzsensor gebildet.

Die Komponenten des optischen Sensors 1 sind in einem Gehäuse 2 integriert, in dessen Frontwand ein Fenster 3 integriert ist. Der optische Sensor 1 weist einen Sender 4 in Form einer Laserdiode auf, der Sendelichtstrahlen 5 in Form von Sendelichtimpulsen emittiert. Dem Sender 4 ist eine Sendeoptik 6 nachgeordnet. Der Sender 4 wird von einer Steuereinheit 7 gesteuert, die an eine Auswerteeinheit 8 angeschlossen ist. Weiterhin weist der optische Sensor 1 einen Empfänger 9 mit einer vorgeordneten Empfangsoptik 10 auf. Die Empfangssignale werden über eine Begrenzerschaltung 11 und eine Verstärkerstufe 12 der Auswerteeinheit 8 zugeführt.

Die vom Sender 4 emittierten Sendelichtstrahlen 5 werden durch das Fenster 3 in den Überwachungsbereich geführt und von einem Objekt 13 zurück zum Empfänger 9 geführt. In der Auswerteeinheit 8 erfolgt eine Laufzeitmessung der Sendelichtimpulse vom Sender 4 zum Objekt 13 und zurück zum Empfänger 9. Aus der ermittelten Laufzeit wird die Distanz oder ein aus der Distanz abgeleitetes Schaltsignal als Objektfeststellungssignal generiert und über einen nicht dargestellten Ausgang ausgegeben.

Der optische Sensor 1 kann als Sicherheitssensor für den Einsatz im Personenschutz ausgebildet sein. Zur Erfüllung der sicherheitstechnischen Anforderungen weist der optische Sensor 1 dann eine redundante Auswerteeinheit 8 auf, beispielsweise in Form zweier sich gegenseitig zyklisch überwachender Rechnereinheiten.

Der optische Sensor 1 gemäß Figur 1 kann dahingehend erweitert sein, dass dieser einen scannenden Distanzsensor bildet.

Gemäß einer ersten Variante sind der Sender 4 und der Empfänger 9 stationär im Gehäuse 2 des optischen Sensors 1 angeordnet. Zudem ist im Gehäuse 2 eine Ablenkeinheit, beispielsweise in Form eines rotierenden, motorisch getriebenen Drehspiegels angeordnet. Mittels der Ablenkeinheit werden die Sendelichtstrahlen 5 des Senders 4 periodisch im Überwachungsbereich geführt.

Gemäß einer zweiten Variante sind der Sender 4 und der Empfänger 9 in einem rotierenden Messkopf untergebracht. Durch die Drehbewegung des Messkopfs werden die Sendelichtstrahlen 5 des Senders 4 periodisch in einem Überwachungsbereichs abgelenkt.

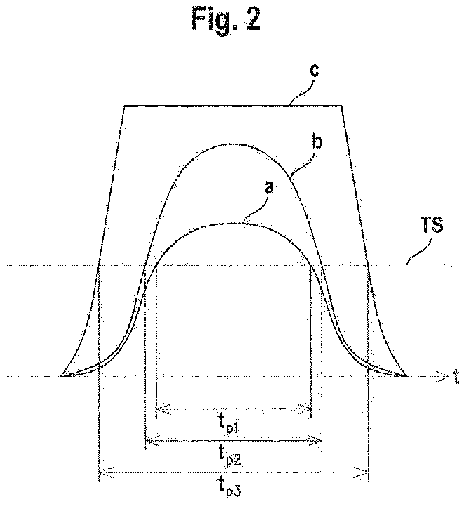

Zur Durchführung der Laufzeitmessungen ist in der Auswerteeinheit 8 ein nicht gesondert dargestellter Zeitmessbaustein integriert. Im Zeitmessbaustein wird eine Laufzeitmessung dann gestartet, wenn der Sender 4 einen Sendelichtimpuls emittiert. Hierzu generiert die Steuereinheit 7 ein entsprechendes Startsignal. Die Laufzeitmessung wird dann gestoppt, wenn das in den Zeitmessbaustein registrierte Empfangssignal eine Triggerschwelle (Figur 2) überschreitet.

Wie Figur 2 zeigt, ist diese Laufzeitmessung abhängig von der Objektreflektivität, das heißt der Reflektivität der Oberfläche des detektierten Objekts 13. Figur 2 zeigt drei zeitliche Empfangssignalverläufe a, b, c für Objekte 13 mit unterschiedlichen Reflektivitäten im jeweils gleichen Abstand zum optischen Sensor 1.

Die Empfangssignale a, b entsprechen der Detektion relativ schwach reflektierender Objekte. Dort befindet sich der Empfänger 9 im linearen Bereich, das heißt das Empfangssignal ist proportional zur Lichtleistung auf dem Empfänger 9. Wie Figur 2 zeigt, nimmt im linearen Bereich mit ansteigender Amplitude des Empfangssignals auch dessen Pulsbreite zu. Dementsprechend wird für das größere Empfangssignal b die Triggerschwelle früher überschritten als für das Empfangssignal a. Damit ergeben sich für unterschiedliche Objektreflektivitäten unterschiedliche Laufzeitwerte. Diese Messfehler, der sogenannte Walk-Error, kann durch eine Kalibrierung der Empfangssignale kompensiert werden.

Figur 2 zeigt weiter ein Empfangssignal c, das von einem hochreflektierenden Objekt wie einem Reflektor stammt. Die Amplitude des Empfangssignals liegt oberhalb des linearen Bereichs des Empfängers 9.

Mit der erfindungsgemäßen Begrenzerschaltung 11 wird verhindert, dass der Empfänger 9 bei derartig hohen Empfangssignalamplituden unkontrolliert über steuert. Die Begrenzerschaltung 11 wirkt dabei derart, dass bei kleinen Amplituden des Empfangssignals, also im linearen Bereich des Empfängers 9, keine Begrenzung des Empfangssignals erfolgt. Jedoch erfolgt mit der Begrenzerschaltung 11 bei hohen Amplituden des Empfangssignals eine nichtlineare Begrenzung, wobei diese Begrenzung unmittelbar und rückwirkungsfrei wirkt. Diese nichtlineare Begrenzung erfolgt dabei derart, dass die Pulsbreite des Empfangssignals nach wie vor mit steigender Lichtleistung am Empfänger 9 zunimmt. Damit kann auch in diesem Bereich die Pulsbreite des Empfangssignals zur Korrektur der Laufzeitmessung herangezogen werden, das heißt auch in diesem Bereich ist eine Kompensation des Walk-Errors möglich.

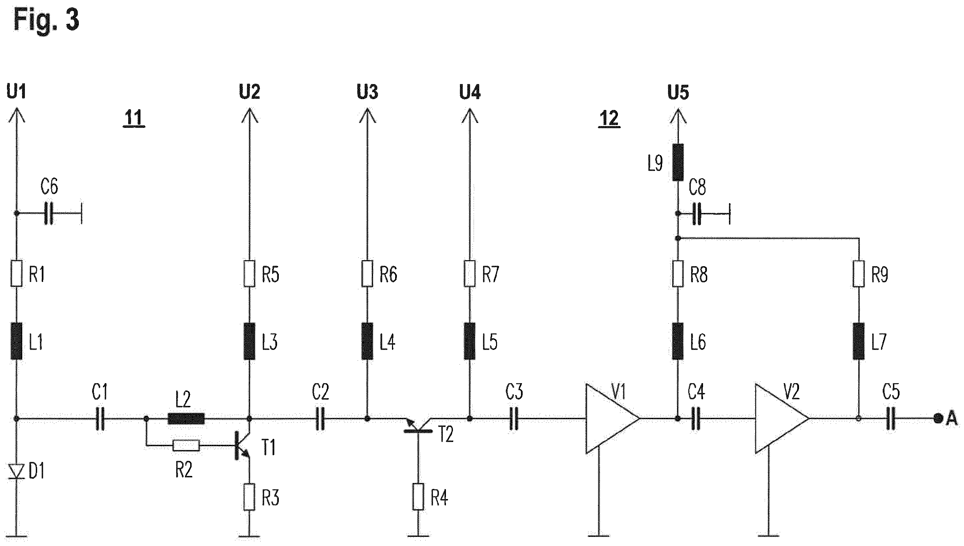

Figur 3 zeigt ein erstes Ausführungsbeispiel der erfindungsgemäßen Begrenzerschaltung 11 mit der nachgeordneten Verstärkerstufe 12.

Eine den Empfänger 9 des optischen Sensors 1 bildende Avalanche-Photodiode D1 liegt einerseits an Masse und ist andererseits über eine Spule L1, einen Widerstand R1 und einen Kondensator C6 an eine Spannung U1 angelegt.

Das Empfangssignal der Avalanche-Photodiode ist über einen Kondensator C1, eine Spule L2 und einem Widerstand R2 der Begrenzerschaltung 11 zugeführt.

Die Begrenzerschaltung 11 weist eine Längsstufe mit einem Transistor T1 und eine Querstufe mit einem Transistor T2 auf, die durch einen Kondensator C2 getrennt sind.

Der Ermitter des Transistors T1 ist über einen Widerstand R3 auf Masse geführt, wobei dessen Kollektor über eine Spule L3 und einen Widerstand R5 an einer Spannung U2 anliegt.

Die Basis des Transistors T2 ist über einen Widerstand auf Masse geführt. Der Ermitter des Transistors T2 liegt über eine Spule L4 und einen Widerstand R6 an einer Spannung U3. Der Kollektor des Transistors T2 liegt über eine Spule L5 und einen Widerstand R7 an eine Spannung U4 an.

Das in der Begrenzerschaltung 11 generierte Signal wird über einen Kondensator C3 der Verstärkerstufe 12 zugeführt, die zwei Verstärker V1, V2 aufweist, denen Spulen L6, L7 und Widerstände R8, R9 zugeordnet sind. Über einen Kondensator C8 und eine Spule L9 erfolgt ein Anschluss an die Spannung U5. Am Ausgang der Verstärkerstufe 12 befindet sich ein Kondensator C5. Das Ausgangssignal A der Begrenzerschaltung 11 mit der nachgeordneten Verstärkerstufe 12 wird der Auswerteeinheit 8 zugeführt.

Die Begrenzerschaltung 11 arbeitet derart, dass nur bei hohen Empfangssignalamplituden, das heißt oberhalb einer Grenzamplitude, die Längsstufe hochohmig wird, jedoch das Empfangssignal noch durchlässt. Die Querstufe leitet bei Empfangssignalamplituden oberhalb einer oder der Grenzamplitude einen Teil des Empfangssignals ab. Der Arbeitspunkt der so gebildeten Begrenzerschaltung 11 ist einstellbar, wobei insbesondere die Längsstufe und die Querstufe aufeinander abgestimmt sind.

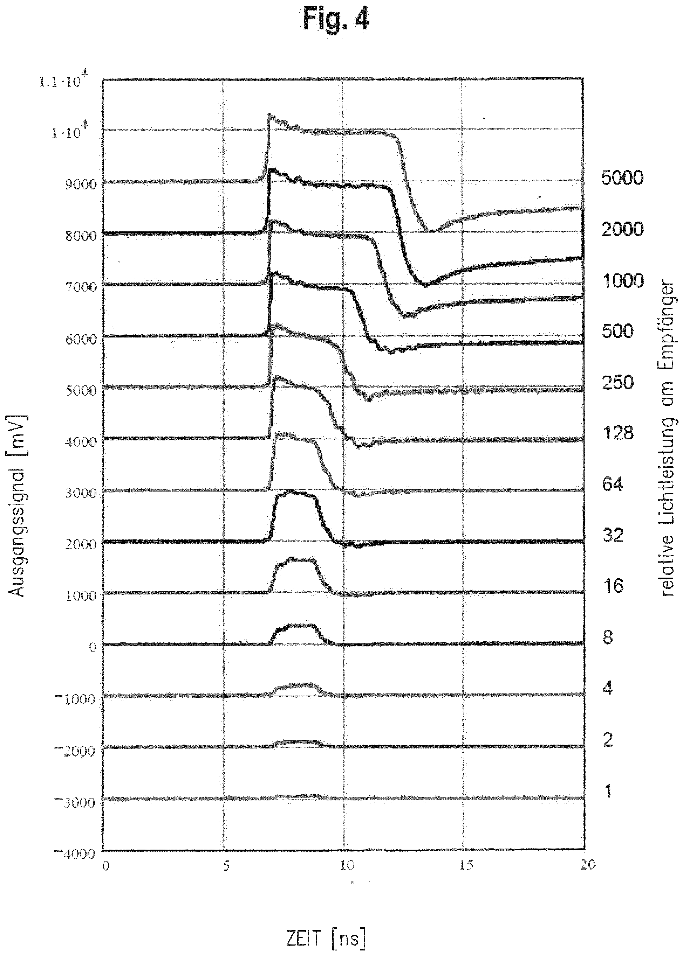

Die Figuren 4 bis 7 zeigen die Funktionsweise der erfindungsgemäßen Begrenzerschaltung 11.

Figur 4 zeigt für die Detektion von Objekten 13 mit unterschiedlicher Objektreflektivität in derselben Distanz zum optischen Sensor 1, wobei die Objektdetektion jeweils mit einem Sendelichtimpuls derselben Pulsbreite detektiert wird. Dabei sind in Figur 4 die am Ausgang der Begrenzerschaltung 11 erhaltenen Ausgangssignale für Objektdetektionen dargestellt, wobei die Objektreflektivität der Objekte 13 von unten nach oben zunimmt, so dass auch die relative Lichtleistung am Empfänger 9 für die einzelnen Objektdetektionen von unten nach oben zunimmt.

Für die einzelnen Objektdetektionen ist jeweils das Ausgangssignal A an der Begrenzerschaltung 11 und Verstärkerstufe 12 aufgetragen.

Bei der Objektdetektion, bei welcher das Ausgangssignal bei 1000 mV erhalten wird, setzt die Signalbegrenzung der Begrenzerschaltung 11 ein. Bei den Signalen mit kleineren Werten des Ausgangssignals erfolgt keine Begrenzung des Empfangssignals.

Wie aus Figur 4 ersichtlich, nimmt bei Objektdetektionen von Objekten 13 mit zunehmender Objektreflektivität die Lichtleistung am Empfänger 9 zu. Mit zunehmender Lichtleistung am Empfänger 9 wird das Empfangssignal in der Begrenzerschaltung 11 zunehmend begrenzt, wobei die Pulsbreite des Ausgangssignals A kontinuierlich zunimmt.

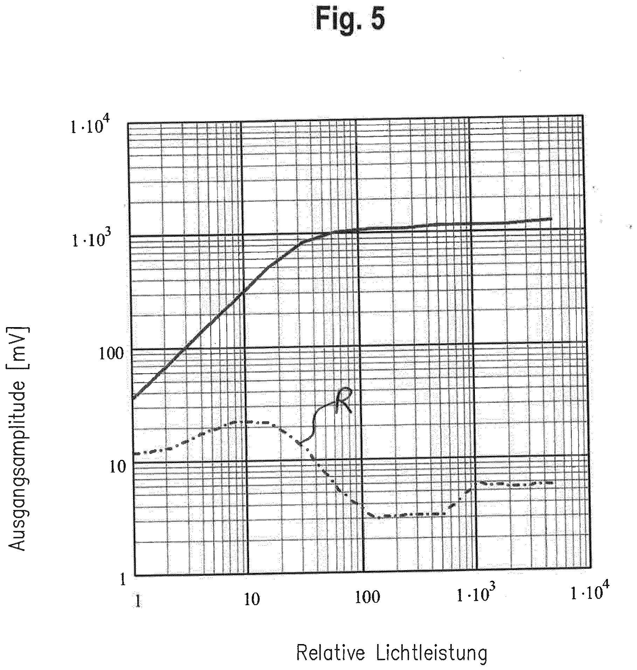

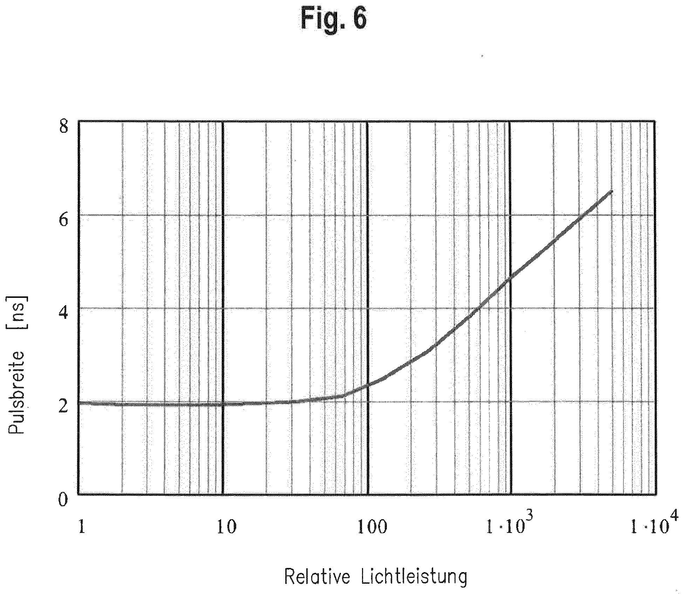

Diese Wirkung der Begrenzerschaltung 11 ist in den Figuren 5 und 6 detaillierter veranschaulicht.

In Figur 5 ist das Ausgangssignal A am Ausgang der Begrenzerschaltung 11 und Verstärkerstufe 12 in Abhängigkeit der Lichtleistung auf den Empfänger 9 aufgetragen. Figur 5 zeigt, dass oberhalb einer relativen Lichtleistung von 40 im Empfänger 9 die Begrenzerschaltung 11 wirksam wird und die Amplitude des Ausgangssignals A auf Wert von ca. 1000 mV begrenzt ist. Im Diagramm von Figur 5 ist zudem die Rauschspannung eingetragen (bezeichnet mit R). Wie Figur 5 zeigt, nimmt das Rauschen mit Einsetzen der Wirkung der Begrenzerschaltung 11 sogar ab.

In Figur 6 ist die Pulsbreite des Ausgangssignals A in Abhängigkeit der Lichtleistung auf dem Empfänger 9 aufgetragen. Wie Figur 6 zeigt, nimmt nach Wirksamwerden der Begrenzerschaltung 11 ab einer Lichtleistung von ca. 40 am Empfänger 9 die Pulsbreite des Ausgangssignals A zu. Diese charakteristische Zunahme der Pulsbreite kann für eine Korrektur des Walk-Errors genutzt werden.

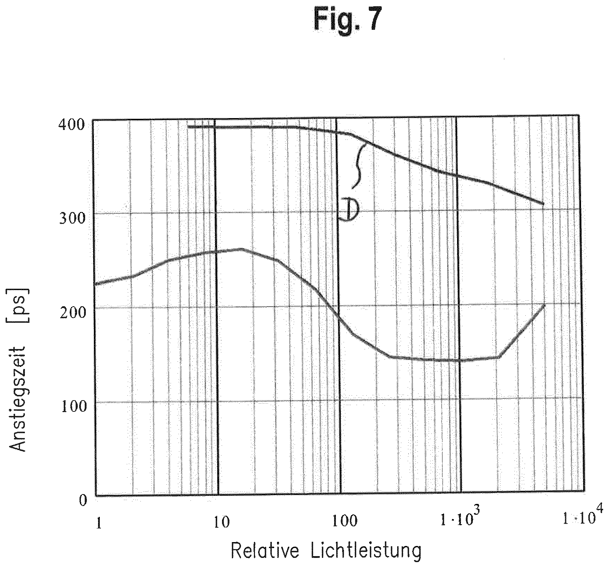

In Figur 7 ist die Anstiegszeit des Ausgangssignals A in Abhängigkeit der Lichtleistung am Empfänger 9 aufgetragen. Zum Vergleich ist in Figur 7 die Anstiegszeit der als Empfänger 9 verwendeten Avalanche-Photodiode dargestellt (in Figur 7 mit D bezeichnet). Wie Figur 7 zeigt, wird durch die Begrenzerschaltung 11 eine deutliche Reduzierung der Anstiegszeit erhalten, wodurch die Genauigkeit der Laufzeitmessungen weiter erhöht wird.

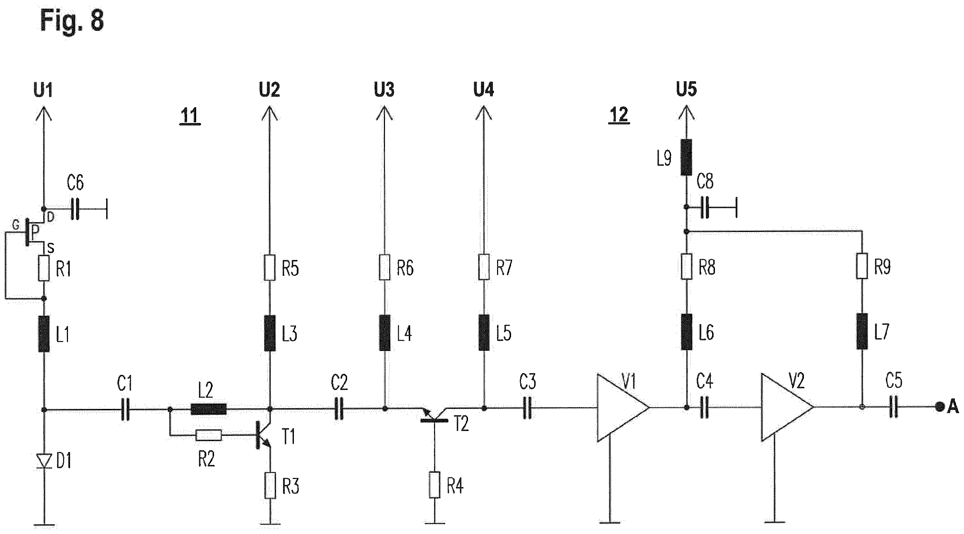

Figur 8 zeigt ein zweites Ausführungsbeispiel der erfindungsgemäßen Begrenzerschaltung 11 mit der nachgeordneten Verstärkerstufe 12. Die Schaltungsanordnung gemäß Figur 8 unterscheidet sich von der Ausführungsform gemäß Figur 3 noch dadurch, dass der Avalanche-Photodiode eine Strombegrenzungsstufe mit einem FET (Feldeffekttransistor) P vorgeordnet ist, wodurch der Strom durch die Avalanche-Photodiode vorab begrenzt wird. Vorzugsweise erfolgt diese Begrenzung bei der Detektion hochreflektierender Objekte 13.

### Bezugszeichenliste

- (1): Optischer Sensor
- (2): Gehäuse
- (3): Fenster
- (4): Sender
- (5): Sendelichtstrahlen
- (6): Sendeoptik
- (7): Steuereinheit
- (8): Auswerteeinheit
- (9): Empfänger
- (10): Empfangsoptik
- (11): Begrenzerschaltung
- (12): Verstärkerstufe
- (13): Objekt

## Patentansprüche

1. Optischer Sensor (1) zur Erfassung von Objekten (13) in einem Überwachungsbereich, mit einem Sender (4), welcher Sendelichtstrahlen (5) in Form von Sendelichtimpulsen emittiert, mit einem Sendelichtimpulse empfangenden Empfänger (9) und mit einer Auswerteeinheit (8), in welcher am Ausgang des Empfängers (9) anstehende Empfangssignale zur Generierung eines Objektfeststellungssignals ausgewertet werden, **dadurch gekennzeichnet, dass** dem Empfänger (9) eine Begrenzerschaltung (11) nachgeordnet ist, welche zwei Begrenzerstufen aufweist, wobei eine erste Begrenzerstufe von einer Längsstufe gebildet ist, welche bei Überschreiten einer Grenzamplitude des Empfangssignals hochohmig ist, und wobei eine zweite Begrenzerstufe von einer Querstufe gebildet ist, mittels derer bei Überschreiten der oder einer weiteren Grenzamplitude des Empfangssignals ein Teil dieses Empfangssignals nach Masse abgeleitet ist, und dass in der Begrenzerschaltung (11) unterhalb der oder jeder Grenzamplitude das Empfangssignal nicht begrenzt ist.

2. Optischer Sensor (1) nach Anspruch 1, **dadurch gekennzeichnet, dass** dieser ein nach einem Puls-Laufzeit-Verfahren arbeitender Distanzsensor ist.

3. Optischer Sensor (1) nach einem der Ansprüche 1 oder 2, **dadurch gekennzeichnet, dass** dieser eine Ablenkeinheit aufweist, mittels derer die vom Sender (4) emittierten Sendelichtstrahlen (5) periodisch innerhalb des Überwachungsbereichs geführt sind.

4. Optischer Sensor (1) nach einem der Ansprüche 1 oder 2, **dadurch gekennzeichnet, dass** der Sender (4) und der Empfänger (9) in einem rotierenden Messkopf gelagert sind, wobei durch die Drehbewegung des Messkopfs die vom Sender (4) emittierten Sendelichtstrahlen (5) periodisch innerhalb des Überwachungsbereichs geführt sind.

5. Optischer Sensor (1) nach einem der Ansprüche 1 bis 4, **dadurch gekennzeichnet, dass** der Empfänger (9) von einer Avalanche-Photodiode oder einer Anordnung von mehreren Avalanche-Photodioden gebildet ist.

6. Optischer Sensor (1) nach einem der Ansprüche 1 bis 5, **dadurch gekennzeichnet, dass** die am Empfänger (9) anstehenden Empfangssignale über die Begrenzerschaltung (11) und eine Verstärkerstufe (12) der Auswerteeinheit (8) zugeführt sind.

7. Optischer Sensor (1) nach einem der Ansprüche 1 bis 6, **dadurch gekennzeichnet, dass** in der Begrenzerschaltung (11) oberhalb der oder jeder Grenzamplitude das Empfangssignal nichtlinear begrenzt ist.

8. Optischer Sensor (1) nach einem der Ansprüche 1 bis 7, **dadurch gekennzeichnet, dass** in der Begrenzerschaltung (11) oberhalb der oder jeder Grenzamplitude das Empfangssignal unmittelbar und rückkopplungsfrei begrenzt ist.

9. Optischer Sensor (1) nach einem der Ansprüche 1 bis 8, **dadurch gekennzeichnet, dass** die Begrenzerschaltung (11) derart ausgebildet ist, dass die Pulsbreite eines von einem Sendelichtimpuls stammenden Empfangssignals mit steigender empfangener Lichtleistung kontinuierlich zunimmt.

10. Optischer Sensor (1) nach Anspruch 9, **dadurch gekennzeichnet, dass** in der Auswerteeinheit (8) die Pulsbreite des Empfangssignals zur Korrektur einer Laufzeitmessung herangezogen wird.

11. Optischer Sensor (1) nach einem der Ansprüche 1 bis 10, **dadurch gekennzeichnet, dass** die Begrenzerschaltung (11) einen einstellbaren Arbeitspunkt aufweist.

12. Optischer Sensor (1) nach einem der Ansprüche 1 bis 11, **dadurch gekennzeichnet, dass** der Strom durch den Empfänger (9) durch eine Strombegrenzungsstufe begrenzt ist.

13. Verfahren zur Erfassung von Objekten (13) in einem Überwachungsbereich mittels eines optischen Sensors (1), umfassend einen Sender (4), welcher Sendelichtstrahlen (5) in Form von Sendelichtimpulse empfangenden Empfänger (9) und eine Auswerteeinheit (8), in welcher am Ausgang des Empfängers (9) anstehende Empfangssignale zur Generierung eines Objektfeststellungssignals ausgewertet werden, **dadurch gekennzeichnet, dass** dem Empfänger (9) eine Begrenzerschaltung (11) nachgeordnet ist, welche zwei Begrenzerstufen aufweist, wobei eine erste Begrenzerstufe von einer Längsstufe gebildet ist, welche bei Überschreiten einer Grenzamplitude des Empfangssignals hochohmig ist, und wobei eine zweite Begrenzerstufe von einer Querstufe gebildet ist, mittels derer bei Überschreiten der oder einer weiteren Grenzamplitude des Empfangssignals ein Teil dieses Empfangssignals nach Masse abgeleitet ist, und dass in der Begrenzerschaltung (11) unterhalb der oder jeder Grenzamplitude das Empfangssignal nicht begrenzt ist.

## Claims

1. An optical sensor (1) for detecting objects (13) in a monitoring area, having a transmitter (4) which emits transmitted light beams (5) in the form of transmitted light pulses, having a receiver (9) which receives transmitted light pulses, and having an evaluation unit (8) in which received signals present at the output of the receiver (9) are evaluated to generate an object detection signal, **characterised in that** a limiter circuit (11) is arranged downstream of the receiver (9), which has two limiter stages, a first limiter stage being formed by a longitudinal stage which has a high impedance when a limit amplitude of the received signal is exceeded, and a second limiter stage being formed by a transverse stage by means of which, when the or a further limit amplitude of the received signal is exceeded, a part of this received signal is derived to earth, and **in that** the received signal is not limited in the limiter circuit (11) below the or each limit amplitude.

2. The optical sensor (1) according to claim 1, **characterized in that** the optical sensor (1) is a distance sensor operating according to a pulse-duration method.

3. The optical sensor (1) according to one of claims 1 or 2, **characterised in that** it has a deflection unit by means of which the transmitted light beams (5) emitted by the transmitter (4) are periodically guided within the monitoring range.

4. The optical sensor (1) according to one of claims 1 or 2, **characterised in that** the transmitter (4) and the receiver (9) are mounted in a rotating measuring head, wherein the transmitted light beams (5) emitted by the transmitter (4) are periodically guided within the monitoring range by the rotary movement of the measuring head.

5. The optical sensor (1) according to one of claims 1 to 4, **characterised in that** the receiver (9) is formed by an avalanche photodiode or an arrangement of several avalanche photodiodes.

6. The optical sensor (1) according to one of claims 1 to 5, **characterised in that** the received signals present at the receiver (9) are fed to the evaluation unit (8) via the limiter circuit (11) and an amplifier stage (12).

7. The optical sensor (1) according to one of claims 1 to 6, **characterised in that** the received signal is non-linearly limited in the limiter circuit (11) above the or each limit amplitude.

8. The optical sensor (1) according to any one of claims 1 to 7, **characterised in that** the received signal is limited directly and without feedback in the limiter circuit (11) above the or each limit amplitude.

9. The optical sensor (1) according to one of claims 1 to 8, **characterised in that** the limiter circuit (11) is designed in such a way that the pulse width of a received signal originating from a transmitted light pulse increases continuously with increasing received light power.

10. The optical sensor (1) according to claim 9, **characterised in that** in the evaluation unit (8) the pulse width of the received signal is used to correct a transit time measurement.

11. The optical sensor (1) according to any one of claims 1 to 10, **characterised in that** the limiter circuit (11) has an adjustable operating point.

12. The optical sensor (1) according to one of claims 1 to 11, **characterised in that** the current through the receiver (9) is limited by a current limiting stage.

13. A method for detecting objects (13) in a monitoring area by means of an optical sensor (1), comprising a transmitter (4), which receives transmitted light beams (5) in the form of transmitted light pulses, and an evaluation unit (8), in which received signals present at the output of the receiver (9) are evaluated to generate an object detection signal, **characterised in that** a limiter circuit (11) is arranged downstream of the receiver (9), which has two limiter stages, a first limiter stage being formed by a longitudinal stage which has a high impedance when a limit amplitude of the received signal is exceeded, and a second limiter stage being formed by a transverse stage by means of which, when the or a further limit amplitude of the received signal is exceeded, a part of this received signal is derived to earth, and **in that** the received signal is not limited in the limiter circuit (11) below the or each limit amplitude.

## Revendications

1. Capteur optique (1) pour la détection d'objets (13) dans une zone de surveillance, comprenant un émetteur (4) qui émet des rayons lumineux d'émission (5) sous la forme d'impulsions de lumière d'émission, un récepteur (9) qui reçoit des impulsions de lumière d'émission, et une unité d'évaluation (8) dans laquelle des signaux de réception présents à la sortie du récepteur (9) sont évalués pour générer un signal de détection d'objet, **caractérisé en ce qu'**un circuit limiteur (11) est disposé en aval du récepteur (9), qui comporte deux étages de limitation, un premier étage de limitation étant formé par un étage longitudinal qui présente une impédance élevée lors du dépassement d'une amplitude limite du signal reçu, et un second étage de limitation étant formé par un étage transversal au moyen duquel, lors du dépassement de l'amplitude limite ou d'une autre amplitude limite du signal reçu, une partie de ce signal reçu est dérivée vers la masse, et **en ce que** le signal reçu n'est pas limité dans le circuit de limitation (11) en dessous de la ou de chaque amplitude limite.

2. Capteur optique (1) selon la revendication 1, **caractérisé en ce que** le capteur optique (1) est un capteur de distance fonctionnant selon un procédé de durée d'impulsion.

3. Capteur optique (1) selon l'une des revendications 1 ou 2, **caractérisé en ce qu'**il présente une unité de déviation au moyen de laquelle les rayons lumineux (5) émis par l'émetteur (4) sont guidés périodiquement dans la plage de surveillance.

4. Capteur optique (1) selon l'une des revendications 1 ou 2, **caractérisé en ce que** l'émetteur (4) et le récepteur (9) sont montés dans une tête de mesure rotative, les rayons lumineux d'émission (5) émis par l'émetteur (4) étant guidés périodiquement dans la plage de surveillance par le mouvement de rotation de la tête de mesure.

5. Capteur optique (1) selon l'une des revendications 1 à 4, **caractérisé en ce que** le récepteur (9) est formé par une photodiode à avalanche ou un agencement de plusieurs photodiodes à avalanche.

6. Capteur optique (1) selon l'une des revendications 1 à 5, **caractérisé en ce que** les signaux de réception présents sur le récepteur (9) sont amenés à l'unité d'évaluation (8) par l'intermédiaire du circuit limiteur (11) et d'un étage amplificateur (12).

7. Capteur optique (1) selon l'une des revendications 1 à 6, **caractérisé en ce que** le signal reçu est limité de manière non linéaire dans le circuit limiteur (11) au-dessus de la ou de chaque amplitude limite.

8. Capteur optique (1) selon l'une quelconque des revendications 1 à 7, **caractérisé en ce que** le signal reçu est limité directement et sans rétroaction dans le circuit limiteur (11) au-dessus de la ou de chaque amplitude limite.

9. Capteur optique (1) selon l'une des revendications 1 à 8, **caractérisé en ce que** le circuit limiteur (11) est conçu de telle manière que la largeur d'impulsion d'un signal reçu provenant d'une impulsion de lumière émise augmente continuellement avec l'augmentation de la puissance lumineuse reçue.

10. Capteur optique (1) selon la revendication 9, **caractérisé en ce que** dans l'unité d'évaluation (8), la largeur d'impulsion du signal reçu est utilisée pour corriger une mesure du temps de transit.

11. Capteur optique (1) selon l'une quelconque des revendications 1 à 10, **caractérisé en ce que** le circuit limiteur (11) présente un point de fonctionnement réglable.

12. Capteur optique (1) selon l'une des revendications 1 à 11, **caractérisé en ce que** le courant traversant le récepteur (9) est limité par un étage limiteur de courant.

13. Procédé de détection d'objets (13) dans une zone de surveillance au moyen d'un capteur optique (1), comprenant un émetteur (4) qui reçoit des rayons lumineux d'émission (5) sous la forme d'impulsions lumineuses d'émission, et une unité d'évaluation (8) dans laquelle les signaux de réception présents à la sortie du récepteur (9) sont évalués pour générer un signal de détection d'objet, **caractérisé en ce qu'**un circuit limiteur (11) est disposé en aval du récepteur (9), qui présente deux étages limiteurs, un premier étage limiteur étant formé par un étage longitudinal qui présente une impédance élevée lorsqu'une amplitude limite du signal reçu est dépassée, et un second étage limiteur étant formé par un étage transversal au moyen duquel, lorsque l'amplitude limite ou une autre amplitude limite du signal reçu est dépassée, une partie de ce signal reçu est dérivée vers la masse, et **en ce que** le signal reçu n'est pas limité dans le circuit limiteur (11) en dessous de l'amplitude limite ou de chaque amplitude limite.
